# EUROPÄISCHE PATENTSCHRIFT

(11) **EP 2 155 499 B1**
(45) Veröffentlichungstag und Bekanntmachung des Hinweises auf die Patenterteilung: **11.01.2012**
(21) Anmeldenummer: 08760108.4
(22) Anmeldetag: 27.05.2008
(51) Int. Cl.: B41M 5/382, B41J 2/005, B41J 2/47

(54) **DRUCKMASCHINE UND DRUCKVERFAHREN HIERFÜR**
PRINTING MACHINE AND PRINTING METHOD THEREFOR
MACHINE À IMPRIMER ET PROCÉDÉ D'IMPRESSION CORRESPONDANT

(30) Priorität: 11.06.2007 DE 102007026883
(43) Veröffentlichungstag der Anmeldung: 24.02.2010
(73) Patentinhaber: Aurentum Innovationstechnologien GmbH, 55129 Mainz (DE); BASF SE, 67056 Ludwigshafen (DE)
(72) Erfinder: LEHMANN, Udo, 64404 Bickenbach (DE)
(74) Vertreter: WSL Patentanwälte Partnerschaftsgesellschaft
(86) Internationale Anmeldenummer: PCT/EP2008/056512
(87) Internationale Veröffentlichungsnummer: WO 2008/151932

(56) Entgegenhaltungen:
- EP-A- 1 987 956
- WO-A-01/72518
- US-A- 4 332 196

## Beschreibung

Die vorliegende Erfindung betrifft eine Druckmaschine mit einem Farbträger und einer Übertragungseinrichtung zur Übertragung von Farbe aus einem Reservoir auf den Farbträger, wobei die Übertragungseinrichtung und der Farbträger so zueinander angeordnet sind, daß ein erster Übertragungsbereich ausgebildet wird, in dem während des Betriebs der Druckmaschine eine Farbe von der Übertragungseinrichtung auf den Farbträger übertragen wird, und mit einer Abgabevorrichtung zur zumindest teilweisen Abgabe der Farbe von dem Farbträger auf einen Bedruckstoff oder ein Übertragungsmittel.

Die Erfindung betrifft darüber hinaus ein Druckverfahren mit den Schritten: Übertragen einer Farbe von einer Übertragungseinrichtung auf einen Farbträger, wobei zumindest abschnittsweise ein zusammenhängender Film der Farbe auf den Farbträger aufgebracht wird, Abgeben zumindest eines Teils der Farbe von dem Farbträger auf einen Bedruckstoff oder ein Übertragungsmittel.

US 4,332,196 offenbart eine Vorrichtung zum Abmessen von Tinte für eine herkömmliche Druckpresse, welche ohne eine Einrichtung zur Erzeugung eines Energiestrahls auskommt. Bei der dort offenbarten Vorrichtung wird überschüssige Farbe von einer Farbkastenrolle abgenommen.

EP 1 987 956 offenbart einen Tintenstrahldrudcer, bei dem überschüssige Farbe von der Drucktrommel abgenommen wird.

Die WO 01/72518 A1 offenbart ein Druckverfahren zur Übertragung einer Farbe von einem Farbträger auf einen Bedruckstoff oder ein Übertragungsmittel, bei dem mittels eines induzierten Vorgangs einer Energie abgebenden Einrichtung die Farbe eine Volumen- und/oder Positionsänderung erfährt und dadurch eine Übertagung eines Druckpunktes auf den Bedruckstoff oder das Übertragungsmittel erfolgt. Dabei wird die Farbe so auf den Farbträger aufgebracht, dass sie einen im wesentlichen durchgehenden Film bildet. In diesen Film wird dann lokal Energie eingebracht, so dass in dem Film punktuell eine Volumen- oder Positionsänderung der Farbe erfolgt, wodurch die Farbe in diesem Bereich von dem Farbträger auf einen Bedruckstoff oder ein Übertragungsmittel übertragen wird.

Nachdem der Übertragungsvorgang von dem Farbträger auf den Bedruckstoff abgeschlossen ist, hat der Film der Farbe auf dem Farbträger seine Homogenität eingebüßt. Es gibt nun Bereiche, in denen die Farbe zumindest teilweise von dem Farbträger entfernt ist, während In anderen Bereichen die Farbe nach wie vor einen Film mit der ursprünglichen Dicke bzw. mit dem ursprünglichen Volumen bildet. Wird nun der Farbträger beispielsweise nach dem Tauchwalzenprinzip mit der gleichen Farbmenge wie zuvor neu eingefärbt, so akkumuliert sich in Bereichen, in denen zuvor Farbe ablatiert wurde, weniger Farbe bzw. Farbsubstanz, während in Bereichen, in denen keine Farbe ablatiert wurde, eine dickere Schicht Farbe aufgebaut wird. Auf diese Weise ist bereits beim zweiten Einfärben des Farbträgers der erzeugte Farbfilm nicht mehr homogen, sondern weist eine ortsabhängige Volumen- und/oder Dickenverteilung auf.

Darüber hinaus weisen viele der verwendeten Druckfarben sich relativ schnell verflüchtigende Lösungsmittel auf, so dass Bereiche des Farbfilms, die länger auf dem Farbträger verbleiben ohne ablatiert zu werden, antrocknen. Daher kann es besonders in Bereichen, die nur seiten ablatiert werden, zu einem Antrocknen und Anhaften des Films der Farbe auf dem Farbträger kommen.

Vor dem Hintergrund dieses Standes der Technik ist es Aufgabe der vorliegenden Erfindung, eine Druckmaschine und ein entsprechendes Druckverfahren bereitzustellen, welche auch nach mehreren Übertragungen von Farbe von dem Farbträger auf einen Bedruckstoff bzw. ein Übertragungsmittel einen homogenen, durchgehenden Film auf dem Farbträger gewährleisten.

Diese Aufgabe wird durch eine Druckmaschine gelöst mit einem Farbträger und einer Übertragungseinrichtung zur Übertragung von Farbe aus einem Reservoir auf den Farbträger, wobei die Übertragungseinrichtung und der Farbträger so zueinander angeordnet sind, daß ein erster Übertragungsbereich ausgebildet wird, in dem während des Betriebs der Druckmaschine eine Farbe von der Übertragungseinrichtung auf den Farbträger übertragen wird, und mit einer Abgabevorrichtung zur zumindest teilweisen Abgabe der Farbe von dem Farbträger auf einen Bedruckstoff oder ein Übertragungsmittel, wobei die Abgabevorrichtung eine Einrichtung zur Erzeugung eines Energiestrahls aufweist, der zum lokalen Eintrag von Energie in die Farbe auf dem Farbträger vorgesehen ist, so dass während des Betriebs der Maschine zumindest ein Teil der Farbe von dem Farbträger auf einen Bedruckstoff oder ein Übertragungsmittel abgegeben wird, wobei sie einen Farbabnehmer aufweist, wobei der Farbträger und der Farbabnehmer so angeordnet sind, daß ein zweiter Übertragungsbereich ausgebildet wird, in dem während des Betriebs der Druckmaschine die nicht verbrauchte Farbe von dem Farbträger auf den Farbabnehmer übertragen wird.

Dabei umfaßt der Begriff Farbe" im Sinne der vorliegenden Erfindung alle Arten von Drucksubstanzen, auch feste Farben. Besonders zweckmäßig ist dabei die Verwendung von flüssigen Farben, beispielsweise Anilinfarben. Vorzugsweise werden Farben mit einer Viskosität kleiner als 10000 mPas und besonders bevorzugt mit einer Viskosität kleiner als 1000 mPas eingesetzt.

Eine derart ausgestaltete Druckmaschine ermöglicht ein Einfärben des Farbträgers, wobei sich die Farbe auf dem Farbträger im permanenten Fluss zwischen einem Vorratsbehälter bzw. Reservoir der Druckmaschine und dem die Farbschicht tragenden Medium, welches als Farbträger bezeichnet wird, befindet. Da auf diese Weise die Farbe auf dem Farbträger permanent nach jedem Bedruckungsvorgang zumindest teilweise, vorteilhafterweise jedoch vollständig erneuert wird, ist ein Farbaufbau oder sogar ein Antrocknen der Farbe nahezu ausgeschlossen.

Darüber hinaus ist es in einer Ausführungsform der Druckmaschine möglich, die Farbschichtdicke auf dem Farbträger stufenlos zu verändern und so einzustellen, dass die übertragene Farbmenge gesteuert werden kann.

Auch wenn Ausführungsformen denkbar sind, in denen die Übertragungseinrichtung eine plattenartige Anordnung ist, so ist in einer Ausführungsform der Erfindung die Übertragungseinrichtung eine Übertragungswalze, die besonders für den kontinuierlichen Betrieb der Druckmaschine geeignet ist. Gleiches gilt für den Farbabnehmer, welcher zweckmäßigerweise walzenförmig ausgestaltet ist.

Der Farbträger, der zu einer Übertragung der Farbe auf einen Bedruckstoff oder ein Übertragungsmittel dient, ist in einer Ausführungsform der Erfindung eine Walze, die um eine Achse drehbar gelagert ist oder ein Endlosband, welches über entsprechende Führungen und/oder Rollen geführt ist und eine endlose Umlaufbewegung ausführen kann.

Das Bedrucken des zu bedruckenden Gegenstandes (auch Bedruckstoff genannt) kann entweder unmittelbar durch eine Übertragung der Farbe von dem Farbträger auf den Bedruckstoff erfolgen oder indirekt durch Übertragen der Farbe von dem Farbträger auf ein Übertragungsmittel (beispielsweise ein Gummituch) und von dort weiter auf den Bedruckstoff.

Beim Bedrucken eines Bedruckstoffs oder eines Übertragungsmittels mit einer Druckmaschine gemäß einer Ausführungsform der vorliegenden Erfindung wird zunächst ein Farbträger mit der Farbe eingefärbt, d.h. auf dem Farbträger wird ein Film aus Farbe aufgetragen, welcher den Farbträger zumindest abschnittsweise, zweckmäßigerweise jedoch vollständig, bedeckt.

Dabei bildet in einer Ausführungsform der Erfindung die Farbe auf dem Farbträger einen im wesentlichen zusammenhängenden kontinuierlichen Film.

Um eine kontinuierliche Auftragung des Farbfilmes auf den Farbträger zu ermöglichen, weist die Übertragungseinrichtung der Druckmaschine in einer Ausführungsform eine Übertragungswalze auf, die so zu dem Farbträger angeordnet ist, dass ein Übertragungsbereich ausgebildet wird, in dem die der Übertragungseinrichtung zugeführte Farbe von der Übertragungseinrichtung auf den Farbträger übertragen wird. In einer Ausführungsform der Erfindung erfolgt dieses Übertragen durch eine Rotation der walzenförmigen Übertragungseinrichtung und eines ebenfalls walzenförmigen Farbträgers um ihre jeweiligen Drehachsen.

In einem nächsten Schritt wird nun die filmartig auf den Farbträger aufgetragene Farbe, d.h. die Farbe von dem Farbträger, auf einen Bedruckstoff oder ein Übertragungsmittel abgegeben.

In einer Ausführungsform wird dazu lokal, d.h. punktweise Energie in die Farbe eingebracht. Durch den Energieeintrag wird die Farbe lokal erwärmt, so dass nachfolgend eine lokale Volumen-und/oder Positionsänderung der Farbe auf dem Farbträger erfolgt, wodurch sich die Farbe in Form eines Druckpunktes in Richtung des zu bedruckenden Gegenstands (Bedruckstoff oder Übertragungsmittel) bewegt und von dem zu bedruckenden Gegenstand aufgenommen wird.

Um punktuell Energie in die Farbe einzuleiten gibt es verschiedene Möglichkeiten. In einer Ausführungsform weist die Abgabevorrichtung eine Einrichtung zur Erzeugung eines Energiestrahls auf, der zum lokalen Eintrag von Energie in die Farbe auf dem Farbträger vorgesehen ist, so daß während des Betriebs der Maschine zumindest ein Teil der Farbe von dem Farbträger auf einen Bedruckstoff oder ein Übertragungsmittel abgegeben wird.Dabei kann der Energiestrahl sowohl eine elektromagnetische Welle, z.B. aus einem Laser, als auch ein Strahl massebehafteter Teilchen, beispielsweise ein Elektronen- oder lonenstrahl, sein.

Der Energieeintrag in die Farbe kann in einer Ausführungsform der Erfindung direkt erfolgen, d.h. durch Absorption oder Aufnahme des Energiestrahls in der Farbe selbst. Dazu wird der Energiestrahl auf die auf dem Farbträger befindliche Farbe gerichtet. Dies kann sowohl von außen als auch bei Verwendung eines möglicherweise hohlzylindrischen, im wesentlichen für den Energiestrahl transparenten Farbträger von innen, d.h. durch den Farbträger hindurch erfolgen.

In einer alternativen Ausführungsform der Erfindung erfolgt der Energieeintrag in die Farbe indirekt, wobei der Energiestrahl von dem Farbträger selbst absorbiert bzw. aufgenommen wird und die Energie beispielsweise in Form von Wärmeleitung von dem Farbträger in die Farbe weitergeleitet wird.

Nach der Ablation oder Übertragung der Farbe von dem Farbträger auf den Bedruckstoff oder das Übertragungsmittel sind in dem Film der Farbe auf dem Farbträger Bereiche entstanden, aus denen Farbe entfernt wurde und in denen daher die Filmdicke der Farbe stark reduziert ist oder die Farbe sogar vollständig entfernt ist.

Um dennoch über den Druckvorgang nach dem nächsten Umlauf des Farbträgers homogene Bedingungen der Farbe bereitzustellen, ist erfindungsgemäß in Prozessrichtung hinter dem Ort des Energieeintrags ein Farbabnehmer angeordnet. Dieser ist in einer Ausführungsform der Erfindung so angeordnet, dass ein zweiter Übertragungsbereich ausgebildet wird, in dem während des Betriebs der Druckmaschine die nichtverbrauchte Farbe von dem Farbträger auf den Farbabnehmer übertragen wird. Auf diese Weise wird der Farbträger nach der teilweisen Ablation von Farbe gereinigt, d.h. von auf dem Farbträger verbleibenden Farbe zumindest teilweise befreit, bevor erneut von der Übertragungseinrichtung Farbe auf den Farbträger aufgebracht wird.

Auch in der in der Einleitung erwähnten WO 01172518 wird ein Farbabnehmer offenbart, welcher zur Reinigung eines Übertragungsmittels vorgesehen ist. Dieser Farbabnehmer reinigt jedoch nur ein Übertragungsmittel, d.h. den Mittler zwischen Farbträger und Bedruckstoff, von Farbrückständen, welche aufgrund ihrer Berührung mit dem Bedruckstoff verunreinigt sind und somit nicht für eine Rückführung in das Farbreservoir geeignet sind. Auch hat der Farbabnehmer aus der WO 01/72518 keine reinigende Wirkung für den Farbträger.

In einer weiteren Ausführungsform der vorliegenden Erfindung ist die Übertragungseinrichtung zum Einfärben des Farbträgers ein System für einen berührungslosen Auftrag der Farbe auf den Farbträger, wie z. B. Tauch-, Sprüh- oder Spülsysteme, elektrostatisch unterstützte Beschichtungssysteme, Dampf- oder Sublimaüonsübertragungssysteme oder ähnliche Systeme zur Auftragung der Farbe.

In einer Ausführungsform der Erfindung weisen die Übertragungseinrichtung, der Farbabnehmer und der Farbträger farbtragende Oberflächen auf, und sind so bewegbar, dass ihre farbtragenden Oberflächen in den Übertragungsbereichen entgegengesetzte Bewegungsrichtungen aufweisen. Dies ermöglicht einen gleichmäßigen Auf- und Abtrag der Farbe auf bzw. von dem Farbträger.

In einer weiteren Ausführungsform der Erfindung sind der Farbabnehmer und die Übertragungseinrichtung miteinander identisch. In einer Ausführungsform werden sie zweckmäßiger Weise durch ein- und dieselbe Walze gebildet. Dabei sind zweckmäßigerweise der erste und der zweite Übertragungsbereich unmittelbar benachbart angeordnet.

Dies ermöglicht es, die Aufgabe des Einfärbens, d.h. des Übertragens von Farbe auf den Farbträger und des Reinigens, d.h. des Übertragens von Farbe von dem Farbträger, mit ein- und derselben Vorrichtung zu ermöglichen.

Dabei ist eine Ausführungsform zweckmäßig, in welcher die Walze, welche die Übertragungseinrichtung und gleichzeitig den Farbabnehmer bildet und die Walze des Farbträgers mit gleicher Drehrichtung drehbar sind. Auf diese Weise bewegen sich in dem Übertragungsbereich, in welchem zum einen Farbe von der Übertragungswalze auf den Farbträger übertragen wird und zum anderen der Farbträger von der nach dem Drucken verbleibenden Farbe befreit wird, die farbtragenden Oberflächen von Übertragungswalze und Farbträger in entgegengesetzten Richtungen.

Sind die Übertragungseinrichtung und der Farbabnehmer als eine einzige Walze realisiert, wobei im Betrieb die Walze der Übertragungseinrichtung bzw. des Farbabnehmers und der Farbträger gleiche Drehrichtungen aufweisen, so ist es zweckmäßig, daß die Walze der Übertragungseinrichtung und der Farbträger einen Abstand voneinander aufweisen, so daß sich Ihre farbtragenden Oberflächen an der Stelle, an der sie sich am nächsten kommen, gerade nicht berühren. So kommt es in unmittelbarere Umgebung des Punktes mit dem geringsten Abstand zwischen den farbtragenden Oberflächen zur Ausbildung des ersten und des zweiten Übertragungsbereiches ohne, daß sich die Walzen durch in Eingriff treten in ihren Drehbewegungen behindern.

Durch eine Veränderung des Abstandes zwischen Übertragungseinrichtung und Farbträger einerseits und Farbträger und Farbabnehmer andererseits läßt sich die Dicke des Farbfilms auf dem Farbträger einstellen.

Darüber hinaus kann die Dicke des Farbfilms durch Variieren der Relativgeschwindigkeiten der farbtragenden Oberflächen von Übertragungseinrichtung, Farbabnehmer und Farbträger eingestellt werden.

In einer Ausführungsform der Erfindung weist die Druckmaschine ein Reservoir für die Farbe und eine Tauchwalze auf, wobei die Tauchwalze so eingerichtet ist, dass sie während des Betriebs der Maschine die Farbe aus dem Reservoir entnimmt. Dabei kann die Tauchwalze in einer Ausführungsform identisch mit der Übertragungseinrichtung sein. In einer alternativen Ausführungsform bestehen jedoch die Übertragungseinrichtung und die Tauchwalze aus voneinander getrennten Elementen, wobei die Tauchwalze Farbe aus dem Reservoir entnimmt und auf die Übertragungseinrichtung überträgt.

In einer Ausführungsform der Erfindung ist die Übertragungseinrichtung aus Gummi gefertigt.

Im Betrieb der erfindungsgemäßen Druckmaschine wird der Farbträger mit Hilfe des Farbabnehmers nach dem Durchführen eines Druckvorgangs von der auf dem Farbträger verbleibenden Farbe befreit, so dass die Übertragungseinrichtung dann auf ihrer farbtragenden Oberfläche die nach dem Druckvorgang auf dem Farbträger verbleibende Farbe trägt. Um diese von der Übertragungseinrichtung zu entfernen, weist die Druckmaschine gemäß einer Ausführungsform der Erfindung eine Farbabnahmeeinrichtung auf, die so angeordnet ist, dass sie während des Betriebs der Druckmaschine nicht verbrauchte Farbe von der Übertragungseinrichtung entfernt. Dabei ist die Farbabnahmeeinrichtung mit einem Reservoir für die Farbe verbunden, so dass die nicht verbrauchte Farbe in das Reservoir zurückgeleitet wird. Auf diese Weise kann ein geschlossener Kreislauf für denjenigen Anteil der Farbe bereitgestellt werden, der während eines Druckvorgangs nicht von dem Farbträger auf den Bedruckstoff oder das Übertragungsmittel abgegeben wird.

Die der Erfindung zugrunde liegende Aufgabe wird auch durch ein Druckverfahren gelöst mit den Schritten: Übertragen einer Farbe von einer Übertragungseinrichtung auf einen Farbträger, wobei zumindest abschnittsweise ein zusammenhängender Film der Farbe auf den Farbträger aufgebracht wird, Abgeben zumindest eines Teils der Farbe von dem Farbträger auf einen Bedruckstoff oder ein Übertragungsmittel, wobei der nicht von dem Farbträger abgegebene Teil der Farbe von dem Farbträger entfernt wird, wobei der Schritt des Abgebens ein lokales Einbringen von Energie in die Farbe auf dem Farbträger aufweist, wodurch zumindest ein Teil der Farbe eine Volumen- und/oder Positionsänderung erfährt und von dem Farbträger auf einen Bedruckstoff oder ein Übertragungsmittel abgegeben wird.

Weitere Vorteile, Merkmale und Anwendungsmöglichkeiten der vorliegenden Erfindung werden anhand der folgenden Beschreibung einer bevorzugten Ausführungsform und der dazugehörigen Figuren deutlich.
- Figur 1: zeigt eine erste Ausführungsform der erfindungsgemäßen Druckmaschine.
- Figur 2: zeigt eine weitere Ausführungsform der erfindungsgemäßen Druckmaschine.

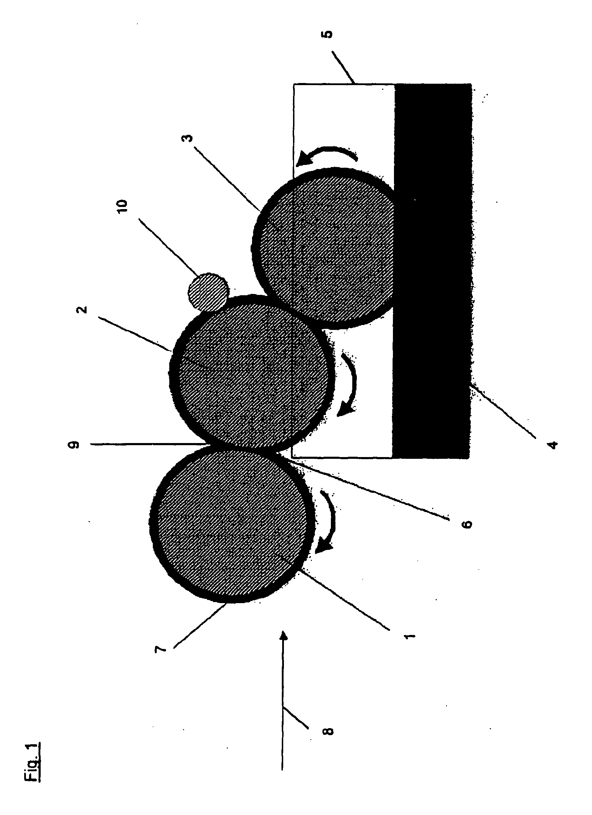

In Figur 1 ist eine schematische seitliche Querschnittsansicht einer ersten Ausführungsform der erfindungsgemäßen Druckmaschine dargestellt. Bei dem gezeigten Druckwerk handelt es sich um ein Walzendruckwerk mit einem walzenförmigen Farbträger 1, einer Gummiwalze 2 als Übertragungseinrichtung sowie einer zusätzlichen Tauchwalze 3.

Die einzelnen Elemente des Druckwerks werden nun nachfolgend anhand der Beschreibung des Bedruckvorgangs erläutert. Dabei wird der Weg der Farbe bzw. Druckfarbe 4 von einem Reservoir 5 bis zum Bedruckstoff (nicht gezeigt) verfolgt.

Die Tauchwalze 3 nimmt die Druckfarbe 4, in der dargestellten Ausführungsform eine Anilinfarbe, aus dem Reservoir 5 auf und überträgt diese auf die Gummiwalze 2. Für diese Übertragung der Farbe 4 von der Tauchwalze 3 auf die Gummiwalze 2 berühren sich die Tauch- 3 und Gummiwalze 2, wobei die beiden Walzen 2, 3 eine entgegengesetzte Drehrichtung aufweisen, so dass ihre Oberflächen im Falle einer Berührung aufeinander ablaufen. In der dargestellten Ausführungsform ist die Tauchwalze 3 als Rasterwalze ausgestaltet.

Die Gummiwalze 2 wiederum befindet sich in unmittelbarer Nähe zu dem Farbträger 1, um eine Übertragung der Farbe 4 von der Gummiwalze 2 auf den Farbträger 1 und umgekehrt von dem Farbträger 1 auf die Gummiwalze 2 zu ermöglichen. Dabei bewegen sich die Gummiwalze 2 und der Farbträger 1 während des Betriebs der Druckmaschine mit gleicher Drehrichtung um ihre Drehachsen, so daß sich ihre farbtragenden Oberflächen im Bereich ihres geringsten Abstandes einander entgegengesetzt bewegen. Während der Rotation der Walzen 1, 2 wird in einem ersten Übertragungsbereich 6, d.h. unterhalb des Punktes mit dem geringsten Abstand zwischen den farbtragenden Oberflächen der Walzen 1, 2 Farbe von der Gummiwalze 2 in Form eines dünnen Farbfilms 7 auf den Farbträger 1 übertragen.

Um den Farbfilm 7 von dem Farbträger 1 in Form von Druckpunkten auf den an dem Farbträger 1 vorbeigeführten Bedruckstoff aufzubringen, wird der Farbträger 1 mit Hilfe eines Laserstrahls 8 punktuell beleuchtet. Der Laserstrahl 8 ist fokussiert und kann über eine entsprechende Ablenkeinrichtung (nicht gezeigt) auf jeden Punkt entlang einer Zeile, die im wesentlichen parallel zur Drehachse des Farbträgers verläuft, fokussiert werden. Der Laserstrahl 8 kann beim Bewegen entlang einer Zeile für jeden Druckpunkt wahlweise ein- oder ausgeschaltet werden. So lässt sich zeilenweise eine beliebige Anordnung von Druckpunkten von dem Farbträger 1 auf einen Bedruckstoff übertragen.

In dem dargestellten Ausführungsbeispiel absorbiert die Farbe 4 die Wellenlänge des eingestrahlten Laserlichts 8 nicht, so dass der auf dem Farbträger 1 befindliche Farbfilm 7 für das Laserlicht transparent ist. Dieses trifft daher im wesentlichen unabgeschwächt auf die Oberfläche des Farbträgers 1, welche eine speziell an die Wellenlänge des Laserlichts 8 angepasste Absorptionsschicht aufweist. Die Absorptionsschicht absorbiert zumindest einen Teil der Energie aus dem Laserstrahl 8 punktuell im Bereich des Brennpunktes des Laserstrahls 8 und gibt diese in Form von Wärme an den Film 7 der Farbe 4 auf den Farbträger 1 ab. Durch die punktuelle schlagartige Erwärmung des Farbfilms 7 wird die indirekt durch den Laserstrahl 8 erwärmten Stelle der Farbfilm ausgedehnt, wodurch er den mit minimalem Abstand an dem Farbträger 1 vorbeigeführten Bedruckstoff berührt, an diesem anhaftet und auf ihn übertragen wird.

In Drehrichtung der Farbwalze 1 hinter dem Auftreff- oder Brennpunkt des Laserstrahls 8 weist der Farbfilm 7 auf dem Farbträger 1 daher Bereiche auf, in denen der Farbfilm 7 unverändert ist und andere Bereiche, in denen Farbe punktweise aus dem Farbfilm 7 auf den Bedruckstoff übertragen wurde. Daher weist der Farbfilm 7 in Drehrichtung hinter dem Brennpunkt des Laserstrahls 8 eine inhomogene Schichtdicke auf.

Um bei einer vollständigen Umdrehung des Farbträgers 1 dennoch erneut eine homogene Schichtdicke des Farbfilms 7 auf den Farbträger 1 zu erhalten, wird nun in einem zweiten Übertragungsbereich 9, d.h. oberhalb des Punktes mit dem geringsten Abstand zwischen den farbtragenden Oberflächen der Gummiwalze 2 und des Farbträgers 1, der auf dem Farbträger 1 verbliebene Farbfilm 7 auf den Gummiträger 2 übertragen.

Im ersten Übertragungsbereich 6 wird dann erneut ein frischer Farbfilm 7 auf den Farbträger 1 aufgetragen, der wie zuvor eine homogene Dicke aufweist und durch den Laserstrahl 8 ablatiert werden kann. Die vom Farbträger 1 auf die Gummiwalze 2 zurück übertragene Farbe wird mit Hilfe einer als Rakel ausgestalteten Farbabnahmeeinrichtung 10 von der Gummiwalze 2 abgenommen und über eine entsprechende Verbindung in das Reservoir 5 zurückgeleitet. Auf diese Weise wird ein geschlossener Kreislauf der Farbe 4 von dem Reservoir 5 über die Tauchwalze 3, die Gummiwalze 2 auf den Farbträger 1 und zurück von dem Farbträger 1 über die Gummiwalze 2 und die Rakel 10 in das Reservoir 5 gebildet.

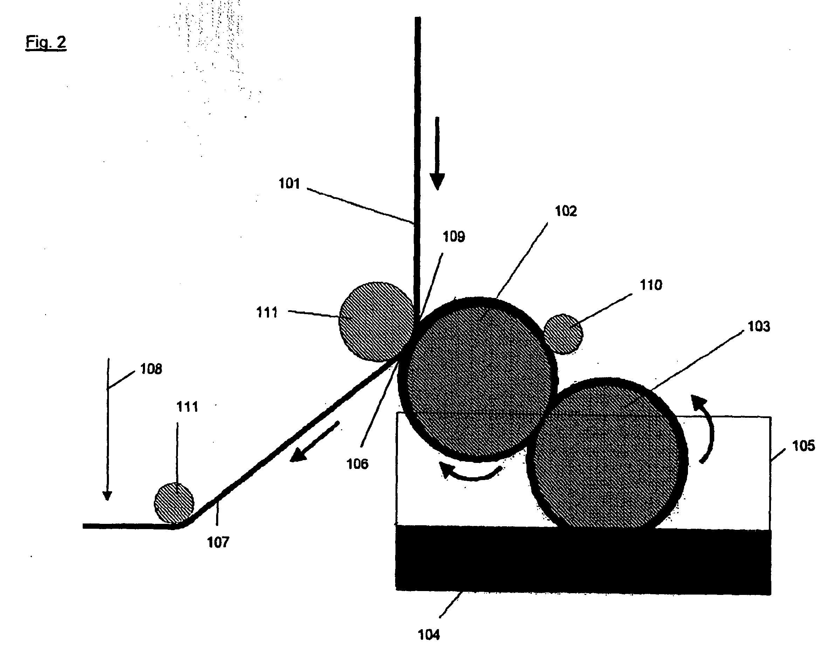

In Figur 2 ist eine alternative Ausführungsform der erfindungsgemäßen Druckmaschine dargestellt, wobei diese sich von der Ausführungsform aus Figur 1 dadurch unterscheidet, dass der walzenförmige Farbträger 1 durch ein Endlosband 101 ersetzt ist. Wie zuvor für die Ausführungsform aus Figur 1 beschrieben, erfolgt der Transport der Farbe 104 aus dem Reservoir 105 mit Hilfe einer Tauchwalze 103 auf eine Gummiwalze 102 und von dort auf das Endlosband 101, welches als Farbträger dient. Die Übertragung der Farbe 104 von der Gummiwalze 102 auf das Endlosband 101 erfolgt im ersten Übertragungsbereich 106, d.h. dem Bereich unterhalb des Punktes des geringsten Abstandes zwischen den farbtragenden Oberflächen der Gummiwalze 102 und des Endlosbandes 101. Im ersten Übertragungsbereich 106 wird die Farbe 104 als dünner zusammenhängender Film 107 auf das Endlosband 101 aufgetragen. Das Endlosband 101 wird mit Hilfe von Leitrollen 111 so geführt, dass es zum einen in unmittelbarer Nähe zurGummiwalze 102 vorbeigeführt wird, zum anderen mit einem Laserstrahl 108 beaufschlagt werden kann.

In der dargestellten Ausführungsform ist das Endlosband 101 für die Wellenlänge der Laserstrahlung 108 transparent, so dass die Laserstrahlung ungehindert durch das Endlosband 101 hindurchtritt bis es auf den auf der anderen Oberfläche des Endlosbandes 101 angeordneten Farbfilm 107 trifft. In der in Figur 2 gezeigten Ausführungsform ist die Farbe 104 und daher der Farbfilm 107 für die Wellenlänge der Laserstrahlung 108 absorbierend, so dass die Energie des Laserstrahls 108 unmittelbar in dem Farbfilm 107 absorbiert wird und aufgrund der punktuellen Erwärmung des Farbfilms 107 zu einer Volumen- und/oder Positionsänderung des im Brennpunkt des Laserstrahls 108 liegenden Abschnittes des Farbfilms 107 führt. Durch die Positionsänderung wird der Druckpunkt auf den Bedruckstoff (nicht gezeigt), der nahe an dem Endlosband 101 vorbeigeführt wird, übertragen.

In Umlaufrichtung des Bandes hinter dem Laserstrahl 108 wird der teilweise ablatierte Farbfilm 107 auf dem Endlosband 101 weitergeführt, bis er im zweiten Übertragungsbereich 109, d.h. oberhalb des Punktes mit dem geringsten Abstand zwischen der farbtragenden Oberfläche des schen Endlosbandes 101 und der Gummiwalze 102 vom Farbträger 101 auf die Gummiwalze 102 übertragen wird, wodurch das Endlosband 101 fast vollständig vor dem nächsten zu durchlaufenden Zyklus von Druckfarbe 104 befreit wird. Die zurück auf die Gummiwalze 102 übertragene Farbe wird mit Hilfe einer Rakel 110 von der Gummiwalze 102 entfernt und mit Hilfe einer entsprechenden Verbindung von der Rakel 110 zurück in das Reservoir 105 geleitet.

Daher bildet auch die in Figur 2 gezeigte Ausführungsform einen geschlossenen Kreislauf für die Farbe 104 von dem Reservoir 105 über die Tauchwalze 103 und die Gummiwalze 102 auf den Farbträger 101 und zurück von dem Farbträger 101 über die Gummiwalze 102 und die Rakel 110 in das Reservoir 105.

Wesentlich ist, dass auch in der in Figur 2 gezeigten alternativen Ausführungsform der Farbträger 101 und die Gummiwalze 102 in ihrem Berührungspunkt 105, 106 so geführt werden, dass sich die farbtragenden Oberflächen in entgegengesetzter Richtung bewegen.

Dabei werden sowohl der Abstand zwischen den farbtragenden Oberflächen der Farbträger (1, 101) und der Übertragungseinrichtungen (2, 102) als auch ihre Relativgeschwindigkeiten in den ersten (6, 106) und zweiten (9, 109) Übertragungsbereichen so eingestellt, daß eine für den jeweiligen Bedruckstoff ausreichende Farbfilmdicke auf dem Farbträger erzielt wird.

Für Zwecke der ursprünglichen Offenbarung wird darauf hingewiesen, dass sämtliche Merkmale, wie sie sich aus der vorliegenden Beschreibung, den Zeichnungen und den Ansprüchen für einen Fachmann erschließen, auch wenn sie konkret nur im Zusammenhang mit bestimmten weiteren Merkmalen beschrieben wurden sowohl einzeln als auch in beliebigen Zusammenstellungen mit anderen der hier offenbarten Merkmale oder Merkmalsgruppen kombinierbar sind, soweit dies nicht ausdrücklich ausgeschlossen wurde oder technische Gegebenheiten derartige Kombination unmöglich oder sinnlos machen. Auf die umfassende, explizite Darstellung sämtlicher denkbarer Merkmalskombinationen wird hier nur der Kürze und der Lesbarkeit der Beschreibung wegen verzichtet.

### Bezugszeichenliste

- 1: Farbträger
- 2: Gummiwalze
- 3: Tauchwalze
- 4: Druckfarbe
- 5: Reservoir
- 6: erster Übertragungsbereich
- 7: dünner Farbfilm
- 8: Laserstrahl
- 9: zweiter Übertragungsbereich
- 10: Farbabnahmeeinrichtung
- 101: Endlosband
- 102: Gummiwalze
- 103: Tauchwalze
- 104: Druckfarbe
- 105: Reservoir
- 106: erster Übertragungsbereich
- 107: Farbfilm
- 108: Laserstrahl
- 109: zweiter Übertragungsbereich
- 110 0: Rakel
- 111: Leitrolle

## Patentansprüche

1. Druckmaschine mit
einem Farbträger (1, 101) und
einer Übertragungseinrichtung (2, 102) zur Übertragung von Farbe aus einem Reservoir (5, 105) auf den Farbträger (1, 101),
wobei die Übertragungseinrichtung (2, 102) und der Farbträger (1, 101) so zueinander angeordnet sind, daß ein erster Übertragungsbereich (6, 106) ausgebildet wird, in dem während des Betriebs der Druckmaschine eine Farbe (4, 104) von der Übertragungseinrichtung (2, 102) auf den Farbträger (1, 101) übertragen wird, und mit
einer Abgabevorrichtung zur zumindest teilweisen Abgabe der Farbe (4, 104) von dem Farbträger (1, 101) auf einen Bedruckstoff oder ein Übertragungsmittel,
wobei die Abgabevorrichtung eine Einrichtung zur Erzeugung eines Energiestrahls (8, 108) aufweist, der zum lokalen Eintrag von Energie In die Farbe (4, 104) auf dem Farbträger (1, 101) vorgesehen ist, so daß während des Betriebs der Maschine zumindest ein Teil der Farbe (4, 104) von dem Farbträger (1, 101) auf einen Bedruckstoff oder ein Übertragungsmittel abgegeben wird,
**dadurch gekennzeichnet, daß** sie einen Farbabnehmer (2, 102) aufweist,
wobei der Farbträger (1, 101) und der Farbabnehmer (2, 102) so angeordnet sind, daß ein zweiter Übertragungsbereich (9. 109) ausgebildet wird, in dem während des Betriebs der Druckmaschine die nicht verbrauchte Farbe (4, 104) von dem Farbträger (1, 101) auf den Farbabnehmer (2, 102) übertragen wird.

2. Druckmaschine nach Anspruch 1, **dadurch gekennzeichnet, daß** die Einrichtung zur Erzeugung eines Energiestrahls (8,108) ein Laser ist.

3. Druckmaschine nach Anspruch 1 oder 2, **dadurch gekennzeichnet, daß** die Übertragungseinrichtung (2, 102), der Farbabnehmer (2, 102) und der Farbträger (1, 101) farbtragende Oberflächen aufweisen und so bewegbar sind, daß ihre farbtragenden Oberflächen in den Übertragungsbereichen (6, 106, 9, 109) die entgegengesetzte Bewegungsrichtung aufweisen.

4. Druckmaschine nach einem der Ansprüche 1 bis 3, **dadurch gekennzeichnet, daß** der Farbabnehmer (2, 102) und die Übertragungseinrichtung (2, 102) identisch sind.

5. Druckmaschine nach einem der Ansprüche 1 bis 4, **dadurch gekennzeichnet, daß** der erste und der zweite Übertragungsbereich (6, 106, 9, 109) unmittelbar benachbart angeordnet sind.

6. Druckmaschine nach einem der Ansprüche 1 bis 5, **dadurch gekennzeichnet, daß** der Farbträger eine Walze (1) oder ein Endlosband (101) ist.

7. Druckmaschine nach einem der Ansprüche 1 bis 6, **dadurch gekennzeichnet, daß** sie ein Reservoir (5, 105) für die Farbe (4, 104) und eine Tauchwalze (3, 103) aufweist, wobei die Tauchwalze (3, 103) so eingerichtet ist, daß sie während des Betriebs der Maschine die Farbe (4, 104) aus dem Reservoir (5, 105) entnimmt und auf die Übertragungseinrichtung (2, 102) aufbringt.

8. Druckmaschine nach einem der Ansprüche 1 bis 7, **dadurch gekennzeichnet, daß** sie eine Farbabnahmeeinrichtung (10, 110) aufweist, die so angeordnet ist, daß sie während des Betriebs der Druckmaschine nicht verbrauchte Farbe von der Übertragungseinrichtung (2. 102) entfernt, und die mit einem Reservoir (5, 105) für die Farbe (4, 104) verbunden ist, so daß die nicht verbrauchte Farbe (4, 104) in das Reservoir (5, 105) zurückgeleitet wird.

9. Druckmaschine nach einem der Ansprüche 1 bis 8, **dadurch gekennzeichnet, daß** die Farbe eine Viskosität aufweist, die kleiner als 10000 mPas und vorzugsweise kleiner als 1000 mPas ist.

10. Druckverfahren mit den Schritten:
Übertragen einer Farbe (4, 104) von einer Übertragungseinrichtung (2, 102) auf einen Farbträger(1, 101),
wobei zumindest abschnittsweise ein zusammenhängender Film (7, 107) der Farbe (4, 104) auf den Farbträger (1, 101) aufgebracht wird,
Abgeben zumindest eines Teils der Farbe (4,104) von dem Farbträger (1, 101) auf einen Bedruckstoff oder ein Übertragungsmittel,
wobei der Schritt des Abgebens ein lokales Einbringen von Energie in die Farbe (4, 104) auf dem Farbträger (1, 101) aufweist, wodurch zumindest ein Teil der Farbe (4, 104) eine Volumen- und/oder Positionsänderung erfährt und von dem Farbträger (1, 101) auf einen Bedruckstoff oder ein Übertragungsmittel abgegeben wird,
**dadurch gekennzeichnet, daß** der nicht von dem Farbträger (1, 101) abgegebene Teil der Farbe (4, 104) von dem Farbträger (1, 101) entfernt wird.

11. Verfahren nach Anspruch 10, **dadurch gekennzeichnet, daß** die Übertragungseinrichtung (2, 102) und der Farbträger (1, 101) farbtragende Oberflächen aufweisen, wobei die Oberflächen der Übertragungseinrichtung (2, 102) und des Farbträgers (1, 101) in dem Bereich, in welchem die Farbe (4, 104) übertragen wird, in entgegengesetzter Richtung bewegt werden.

12. Verfahren nach Anspruch 10 oder 11, **dadurch gekennzeichnet, daß** die Farbe (4, 104) zum Entfernen von dem Farbträger (1, 101) auf einen Farbabnehmer (2,102) übertragen wird, wobei der Farbträger (1, 101) und der Farbabnehmer (2, 102) farbtragende Oberflächen aufweisen, wobei die farbtragenden Oberflächen des Farbträgers (1, 101) und des Farbabnehmers (2, 102) in dem Bereich, in welchem die Farbe (4, 104) übertragen wird, in entgegengesetzter Richtung bewegt werden.

13. Verfahren nach einem der Ansprüche 10 bis 12, **dadurch gekennzeichnet, daß** die Relativgeschwindigkeit zwischen den farbtragenden Oberflächen der Übertragungseinrichtung (2, 102) und dem Farbträger (1, 101) und/oder dem Farbträger (1, 101) und dem Farbabnehmer (2, 102) variiert werden, um die Filmdicke der Farbe (4, 104) einzustellen.

## Claims

1. A printing machine having a colorant support (1, 101) and a transfer device (2, 102) to transfer colorant from a reservoir (5, 105) onto the colorant support (1, 101), wherein the transfer device (2, 102) and the colorant support (1, 101) are arranged with respect to each other in such a manner that a first transfer zone (6, 106) is formed in which, during operation of the printing machine, a colorant (4, 104) is transferred from the transfer device (2, 102) onto the colorant support (1, 101), and being provided with a delivery apparatus to deliver at least part of the colorant (4, 104) from the colorant support (1, 101) onto a printing medium or a transfer means, wherein the delivery device is provided with a device for the production of a beam of energy (8, 108) which is provided for the localized application of energy to the colorant (4, 104) on the colorant support (1, 101), so that during operation of the machine, at least a portion of the colorant (4, 104) is delivered to a printing medium or a transfer means from the colorant support (1, 101),
**characterized in that** it is provided with a colorant stripper (2, 102) whereby the colorant support (1, 101) and the colorant stripper (2, 102) are arranged so that a second transfer zone (9, 109) is formed in which, during the operation of the printing machine, the non-consumed colorant (4, 104) is transferred from the colorant support (1, 101) onto the colorant stripper (2, 102).

2. A printing machine according to claim 1, **characterized in that** the device for producing a beam of energy (8, 108) is a laser.

3. A printing machine according to claim 1 or 2, **characterized in that** the transfer device (2, 102), the colorant stripper (2, 102) and the colorant support (1, 101) are provided with colorant supporting surfaces and are movable such that their colorant supporting surfaces move in opposite directions in the transfer zones (6, 106, 9, 109).

4. A printing machine according to one of claims 1 to 3, **characterized in that** the colorant stripper (2, 102) and the transfer device (2, 102) are identical.

5. A printing machine according to one of claims 1 to 4, **characterized in that** the first and the second transfer zone (6, 106, 9, 109) are arranged immediately adjacent to each other.

6. A printing machine according to one of claims 1 to 5, **characterized in that** the colorant support is a roller (1) or a continuous band (101).

7. A printing machine according to one of claims 1 to 6, **characterized in that** it is provided with a reservoir (5, 105) for the colorant (4, 104) and a dipping roller (3, 103), wherein the dipping roller (3, 103) is arranged so that, during operation of the machine, colorant (4, 104) is removed from the reservoir (5, 105) and applied to the transfer device (2, 102).

8. A printing machine according to one of claims 1 to 7, **characterized in that** it is provided with a colorant stripping device (10, 110) which is arranged such that, during operation of the printing machine, non-consumed colorant is removed from the transfer device (2, 102) and is linked to a reservoir (5, 105) for the colorant (4, 104) so that the non-consumed colorant (4, 104) is guided back to the reservoir (5, 105).

9. A printing machine according to one of claims 1 to 8, **characterized in that** the viscosity of the colorant is less than 10000 mPas, preferably less than 1000 mPas.

10. A printing process with the following steps:
transferring a colorant (4, 104) from a transfer device (2, 102) onto a colorant support (1, 101), whereby at least part of a coherent film (7, 107) of the colorant (4, 104) is applied to the colorant support (1, 101);
applying at least a portion of the colorant (4, 104) from the colorant support (1, 101) onto a printing medium or a transfer means, wherein the delivery step includes locally applying energy to the colorant (4, 104) on the colorant support (1, 101), whereupon at least a part of the colorant (4, 104) undergoes a change in volume or position and is delivered from the colorant support (1, 101) onto a printing medium or a transfer means, **characterized in that** the portion of the colorant (4, 104) which is not delivered from the colorant support (1, 101) is stripped from the colorant support (1, 101).

11. A process according to claim 10, **characterized in that** the transfer device (2, 102) and the colorant support (1, 101) are provided with colorant supporting surfaces, wherein the surfaces of the transfer device (2, 102) and the colorant support (1, 101) move in opposite directions in the zone in which the colorant (4, 104) is transferred.

12. A process according to claim 10 or 11, **characterized in that** the colorant (4, 104) is transferred onto a colorant stripper (2, 102) from the colorant support (1, 101) for removal, whereby the colorant support (1, 101) and the colorant stripper (2, 102) are provided with colorant supporting surfaces, wherein the colorant supporting surfaces of the colorant support (1, 101) and the colorant stripper (2, 102) move in opposite directions in the zone in which the colorant (4, 104) is transferred.

13. A process according to one of claims 10 to 12, **characterized in that** the relative velocity between the colorant supporting surfaces of the transfer device (2, 102) and the colorant support (1, 101) and/or the colorant support (1, 101) and the colorant stripper (2, 102) are varied in order to adjust the thickness of the film of colorant (4, 104).

## Revendications

1. Machine à imprimer comportant
un support de couleur (1, 101) et
un dispositif de transfert (2, 102) destiné à transférer une couleur d'un réservoir (5, 105) sur un support de couleur (1, 101),
le dispositif de transfert (2, 102) et le support de couleur (1, 101) étant disposés l'un par rapport à l'autre de façon à former une première zone de transfert (6, 106) dans laquelle une couleur (4, 104) est transférée par le dispositif de transfert (2, 102) sur le support de couleur (1, 101) pendant le fonctionnement de la machine à imprimer, et
un dispositif de dépôt destiné à déposer au moins partiellement la couleur (4, 104) du support de couleur (1, 101) sur un matériau d'impression ou un moyen de transfert,
le dispositif de dépôt comportant un dispositif de génération d'un faisceau énergétique (8, 108) qui est destiné à injecter localement de l'énergie dans la couleur (4, 104) sur le support de couleur (1, 101) de sorte que, pendant le fonctionnement de la machine, au moins une partie de la couleur (4, 104) est déposée du support de couleur (1, 101) sur un matériau d'impression ou un moyen de transfert,
**caractérisée en ce qu'**elle comporte un détacheur de couleur (2, 102), le support de couleur (1, 101) et le détacheur de couleur (2, 102) étant disposés de façon à former une seconde zone de transfert (9, 109) dans laquelle la couleur (4, 104) non utilisée est transférée du support de couleur (1, 101) sur le détacheur de couleur (2, 102) pendant le fonctionnement de la machine à imprimer.

2. Machine à imprimer selon la revendication 1, **caractérisée en ce que** le dispositif de génération d'un faisceau énergétique (8, 108) est un laser.

3. Machine à imprimer selon la revendication 1 ou 2, **caractérisée en ce que** le dispositif de transfert (2, 102), le détacheur de couleur (2, 102) et le support de couleur (1, 101) possèdent des surfaces porteuses de couleur et sont déplaçables de telle sorte que leurs surfaces porteuses de couleur dans les régions de transfert (6, 106, 9, 109) ont des directions de déplacement opposées.

4. Machine à imprimer selon l'une des revendications 1 à 3, **caractérisée en ce que** le détacheur de couleur (2, 102) et le dispositif de transfert (2, 102) sont identiques.

5. Machine à imprimer selon l'une des revendications 1 à 4, **caractérisée en ce que** les première et seconde zones de transfert (6, 106, 9, 109) sont disposées juste à côté l'un de l'autre.

6. Machine à imprimer selon l'une des revendications 1 à 5, **caractérisée en ce que** le support de couleur est un cylindre (1) ou une bande sans fin (101).

7. Machine à imprimer selon l'une des revendications 1 à 6, **caractérisée en ce qu'**elle comporte un réservoir (5, 105) destiné à la couleur (4, 104) et un cylindre plongeur (3, 103), le cylindre plongeur (3, 103) étant disposé de telle sorte qu'il prend la couleur (4, 104) dans le réservoir (5, 105) pendant le fonctionnement de la machine et l'applique sur le dispositif de transfert (2, 102).

8. Machine à imprimer selon l'une des revendications 1 à 7, **caractérisée en ce qu'**elle comporte un dispositif de détachement de couleur (10, 110) qui est disposé de telle sorte qu'il enlève de la couleur non utilisée du dispositif de transfert (2, 102) pendant le fonctionnement de la machine à imprimer et qui est relié à un réservoir (5, 105) destiné à la couleur (4, 104) de sorte que la couleur (4, 104) non utilisée est ramenée dans le réservoir (5, 105).

9. Machine à imprimer selon l'une des revendications 1 à 8, **caractérisée en ce que** la couleur présente une viscosité qui est inférieure à 10000 mPas et de préférence inférieure 1000 mPas.

10. Procédé d'impression comportant les étapes consistant à :
transférer une couleur (4, 104) d'un dispositif de transfert (2, 102) sur un support de couleur (1, 101),
un film continu (7, 107) de la couleur (4, 104) étant appliqué au moins par portion sur le support de couleur (1, 101),
déposer au moins une partie de la couleur (4, 104) du support de couleur (1, 101) sur un matériau d'impression ou un moyen de transfert,
l'étape de dépôt comportant une injection locale d'énergie dans la couleur (4, 104) sur le support de couleur (1, 101) de sorte que au moins une partie de la couleur (4, 104) subit une modification de volume et/ou de position et est déposée du support de couleur (1, 101) sur un matériau d'impression ou un moyen de transfert,
**caractérisé en ce que** la partie de la couleur (4, 104) qui n'a pas été déposée par le support de couleur (1, 101) est retirée du support de couleur (1, 101).

11. Procédé selon la revendication 10, **caractérisé en ce que** le dispositif de transfert (2, 102) et le support de couleur (1, 101) possèdent des surfaces porteuses de couleur, les surfaces du dispositif de transfert (2, 102) et du support de couleur (1, 101), dans la région dans laquelle la couleur (4, 104) est transférée, sont déplacées dans des directions opposées.

12. Procédé selon la revendication 10 ou 11, **caractérisé en ce que** la couleur (4, 104) à enlever du support de couleur (1, 101) est transférée sur un détacheur de couleur (2, 102), le support de couleur (1, 101) et le détacheur de couleur (2, 102) possédant des surfaces porteuses de couleur, les surfaces porteuses de couleur du support de couleur (1, 101) et du détacheur de couleur (2, 102), dans la région dans laquelle la couleur (4, 104) est transférée, sont déplacées dans des directions opposées.

13. Procédé selon l'une des revendications 10 à 12, **caractérisé en ce que** la vitesse relative entre les surfaces porteuses de couleur du dispositif de transfert (2, 102) et le support de couleur (1, 101) et/ou le support de couleur (1, 101) et le détacheur de couleur (2, 102) est modifiée afin de régler l'épaisseur de film de la couleur (4, 104).
